# EUROPEAN PATENT APPLICATION

(11) **EP 2 476 778 A1**
(43) Date of publication of application: **18.07.2012**
(21) Application number: 11189645.2
(22) Date of filing: 18.11.2011
(51) Int. Cl.: C23C 16/458, C30B 25/14, C30B 25/12

(54) **Susceptor.**

(30) Priority: 18.01.2011 KR 20110005008
(71) Applicant: Samsung LED Co., Ltd., Gyeonggi-do 443-743 (KR)
(72) Inventor: Han, Kyung-don, Suwon-si Gyeonggi-do (KR)
(74) Representative: Grünecker, Kinkeldey, Stockmair & Schwanhäusser

(57) **Abstract**

Susceptor and chemical vapor deposition (CVD) apparatus including the same. The susceptor includes: a plurality of susceptor slices (110-1) that form a disk when combined together; and at least one pocket (111) disposed on an upper surface of each of the plurality of susceptor slices and containing a member on which a material is to be deposited, wherein, a connection part (112,113) is formed between side surfaces of neighboring susceptor slices and allows the plurality of susceptor slices to be combined to each other in a separable/detachable manner.

## Description

### BACKGROUND

### 1. Field

The present disclosure relates to susceptors and chemical vapor deposition (CVD) apparatuses including the same.

### 2. Description of the Related Art

In general, chemical vapor deposition (CVD) apparatuses use a chemical reaction to form a thin film on a member on which a material is to be deposited (the member generally including a substrate such as a semiconductor wafer). For example, in a CVD apparatus, by transmitting a reaction gas having a high vapor pressure to a substrate heated in a vacuum chamber, a membrane formed of the reaction gas is grown on the substrate.

Currently, due to miniaturization of semiconductor devices and development of high-efficiency and high-output light emitting diodes (LEDs), there has recently been interest in CVD such as metal organic chemical vapor deposition (MOCVD). Also, as sizes of chambers and susceptors increase, a technology of uniform growing a thin film on a plurality of members on which a material is to be deposited is important since the technology allows deposition to occur on all the plurality of members at once. Here, the members are placed on satellite disks, and the satellite disks are each contained in one of a plurality of pockets prepared on susceptors. In order to uniformly grow a thin film on a member on which a material is to be deposited, not only the susceptor but also the satellite disk may rotate.

### SUMMARY

Provided are susceptors having improved structures and chemical vapor deposition (CVD) apparatuses including the same.

Additional aspects will be set forth in part in the description which follows and, in part, will be apparent from the description, or may be learned by practice of the presented embodiments.

According to an aspect of the present invention, a susceptor for a disk-form chemical vapor deposition (CVD) apparatus includes a plurality of susceptor slices that form a disk when combined together; and at least one pocket disposed on an upper surface of each of the plurality of susceptor slices and containing a member on which a material is to be deposited, wherein, a connection part is formed between side surfaces of neighboring susceptor slices and allows the plurality of susceptor slices to be combined to each other in a separable/detachable manner.

The plurality of susceptor slices each may be fan shaped.

The connection part may include a concave portion formed on one side of each of the plurality of susceptor slices and a convex portion formed on another side of each of the plurality of susceptor slices, the concave portion and the convex portion being engaged with each other.

The connection part may include a groove part formed on one side of each of the plurality of susceptor slices and extending long in a diameter direction, and a protrusion part formed on another side of each of the plurality of susceptor slices.

Each of the plurality of susceptor slices may include a susceptor flow path that supplies a flow gas to the at least one pocket.

According to another aspect of the present invention, a chemical vapor deposition (CVD) apparatus includes a susceptor comprising a plurality of susceptor slices that form a disk when combined together and at least one pocket disposed on an upper surface of each of the plurality of susceptor slices and containing a member on which a material is to be deposited; supporters for supporting the susceptor while injecting a flow gas to the susceptor to rotate the member; a reaction gas injector for injecting a reaction gas including a deposition material to be deposited on the member; and a chamber comprising the susceptor, the supporters, and the reaction gas injector, wherein the susceptor is for a disk-form CVD apparatus and includes: a plurality of susceptor slices that form a disk when combined together; and at least one pocket disposed on an upper surface of each of the plurality of susceptor slices and containing a member on which a material is to be deposited, and wherein a connection part is formed between side surfaces of neighboring susceptor slices and allows the plurality of susceptor slices to be combined to each other in a separable/detachable manner.

### BRIEF DESCRIPTION OF THE DRAWINGS

These and/or other aspects will become apparent and more readily appreciated from the following description of the embodiments, taken in conjunction with the accompanying drawings of which:

FIG. 1 is a cross-sectional view schematically illustrating a chemical vapor deposition (CVD) apparatus according to an embodiment of the present invention;

FIG. 2 is a cross-sectional perspective view schematically illustrating a susceptor of the CVD apparatus of FIG. 1;

FIG. 3 is a plan view of the susceptor of FIG. 2; and

FIG. 4 is a perspective view illustrating one slice of the susceptor of FIG. 2.

### DETAILED DESCRIPTION

Hereinafter, embodiments of the present invention will be described more fully with reference to the accompanying drawings. In the drawings, like reference numerals denote like elements, and sizes and thicknesses of elements are exaggerated for clarity.

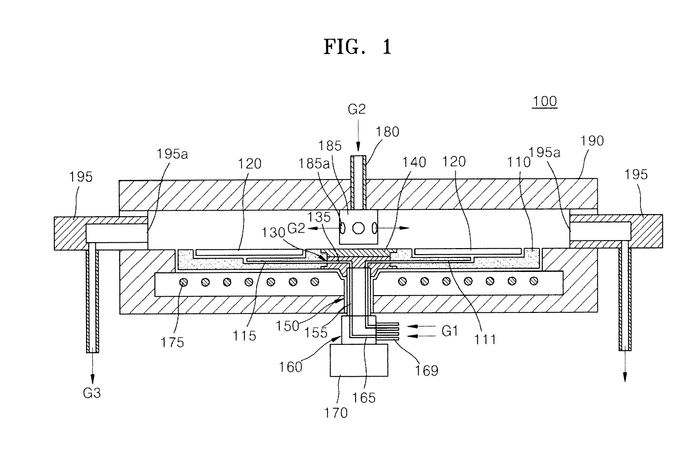

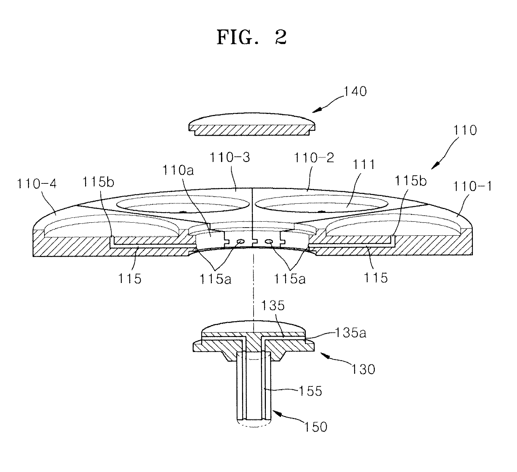

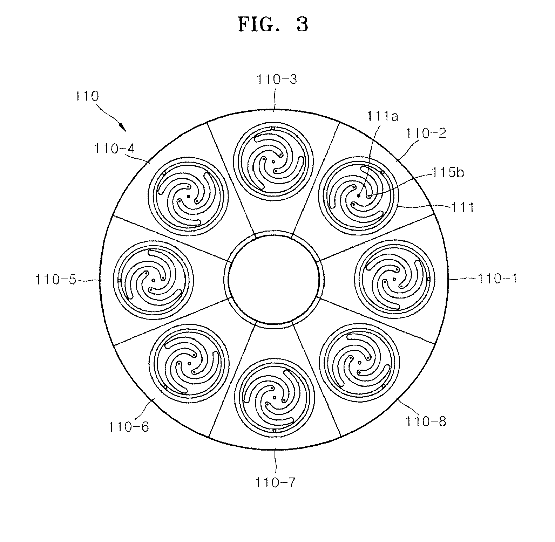

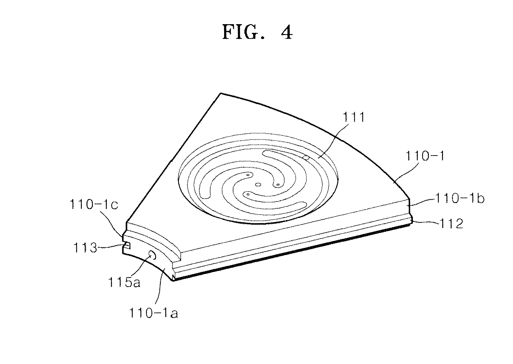

FIG. 1 is a cross-sectional view schematically illustrating a chemical vapor deposition (CVD) apparatus 100 according to an embodiment of the present invention, FIG. 2 is a cross-sectional perspective view schematically illustrating a susceptor 110 of the CVD apparatus 100, FIG. 3 is a plan view of the susceptor 110, and FIG. 4 is a perspective view illustrating one slice 110-1 of the susceptor 110.

Referring to FIG. 1, the CVD apparatus 100 according to the current embodiment of the present invention includes the susceptor 110, supporters 130, 140, and 150 for supporting the susceptor 110 while injecting a flow gas G1, a heater 175 for heating the susceptor 110, a reaction gas injector 180 for supplying a reaction gas G2, a chamber 190 for accommodating the susceptor 110 and a nozzle 185 of the reaction gas injector 180, and a gas discharger 195 for discharging the flow gas G1 and the reaction gas G2 in the chamber 190.

Referring to FIGS. 2 and 3, the susceptor 110 is in a disk form having a hole 110a. The susceptor 110 includes a plurality of susceptor slices 110-1, 110-2, 110-3, 110-4, 110-5, 110-6, 110-7, and 110-8 that form a disk when combined together. In the current embodiment, the susceptor 110 includes eight susceptor slices 110-1, 110-2, 110-3, 110-4, 110-5, 110-6, 110-7, and 110-8. However, the present invention is not limited thereto and the number of susceptor slices may vary according to sizes of the susceptor 110 and pockets 111.

FIG. 4 illustrates the susceptor slice 110-1. Referring to FIG. 4, the susceptor slice 110-1 may be fan shaped having an inner surface 110-1 a that forms a portion of the hole 110a of the susceptor 110, an outer surface 110-1b that forms an arc, and side surfaces 110-1c and 110-1d contacting neighboring susceptor slices. Also, the side surface 110-1c includes a protrusion part 112 and the side surface 110-1d includes a groove part 113. The protrusion part 112 may be formed extending long in a diameter direction, or a plurality of protrusion parts 112 may be discontinuously formed in a diameter direction. The groove part 113 may be formed extending long in a diameter direction. The protrusion part 112 of one slice and the groove part 113 of another slice are complementarily with each other and together form a connection part that allows the plurality of susceptor slices 110-1, 110-2, 110-3, 110-4, 110-5, 110-6, 110-7, and 110-8 to be combined in a separable/detchable manner. That is, the protrusion part 112 of the susceptor slice 110-1 may be fixed into the neighboring groove part 113 prepared in the susceptor slice 110-8 of FIG. 3, and the protrusion part 112 of the susceptor slice 110-2 of FIG. 3 may be fixed into the neighboring groove part 113 of the susceptor slice 110-1 in order to combine the susceptor slice 110-1 and both susceptor slices 110-2 and 110-8 to each other. Such a connection part may be easily disassembled using a sliding method. Thus, when any one of the plurality of susceptor slices 110-1, 110-2, 110-3, 110-4, 110-5, 110-6, 110-7, and 110-8 is broken, the broken susceptor slice may be easily removed and replaced by an extra susceptor slice and thus maintenance is possible.

In the current embodiment, as the plurality of susceptor slices 110-1, 110-2, 110-3, 110-4, 110-5, 110-6, 110-7, and 110-8 have the same shape and thus there is only one kind of slice. In some cases, there may be a plurality of shapes among the plurality of susceptor slices 110-1, 110-2, 110-3, 110-4, 110-5, 110-6, 110-7, and 110-8. For example, in the plurality of susceptor slices 110-1, 110-2, 110-3, 110-4, 110-5, 110-6, 110-7, and 110-8, both side surfaces 110-1c and 110-1d of some slices may include only the protrusion part 112 and both side surfaces 110-1 c and 110-1 d of other slices may include only the groove part 113 and thus these two kinds of slices may be alternately combined to each other.

The protrusion part 112 and the groove part 113 are examples of the connection part; however, the present invention is not limited thereto. For example, instead of the protrusion part 112 and the groove part 113, as is well known, a detachable screw may be used as a connection member.

Referring back to FIGS. 2 and 3, at least one pocket 111 is prepared on an upper surface of each of the plurality of susceptor slices 110-1, 110-2, 110-3, 110-4, 110-5, 110-6, 110-7, and 110-8. In the current embodiment, one pocket 111 is included in each of the susceptor slices 110-1, 110-2, 110-3, 110-4, 110-5, 110-6, 110-7, and 110-8; however, the present invention is not limited thereto. For example, a plurality of pockets 111 may be included in each of the susceptor slices 110-1, 110-2, 110-3, 110-4, 110-5, 110-6, 110-7, and 110-8.

The pocket 111 is a groove part that is concave to a predetermined depth from the upper surface of each of the plurality of susceptor slices 110-1, 110-2, 110-3, 110-4, 110-5, 110-6, 110-7, and 110-8. A disk type satellite disk 120 of FIG. 1 is accommodated in the pocket 111. A center pin 111a may be disposed at the center of the pocket 111 so that the satellite disk 120 is not separated from the pocket 111 while the satellite disk 120 is rotating.

A susceptor flow path 115 for supplying the flow gas G1 to the pocket 111 is formed in each of the plurality of susceptor slices 110-1, 110-2, 110-3, 110-4, 110-5, 110-6, 110-7, and 110-8. An inlet 115a of the susceptor flow path 115 may be disposed in the side of the hole 110a of the susceptor 110. An outlet 115b of the susceptor flow path 115 is disposed at a bottom of the pocket 111. For example, a plurality of outlets 115b of the susceptor flow path 115 may be disposed at the bottom of the pocket 111. In this case, one susceptor flow path 115 may diverge into the plurality of outlets 115b. As the inlet 115a of the susceptor flow path 115 is disposed in the side of the hole 110a of the susceptor 110, the susceptor flow path 115 extends long in a straight line from the inlet 115a to a lower part of the pocket 111 and is bent to the outlet 115b on the pocket 111 from the lower part of the pocket 111. In some cases, the inlet 115a of the susceptor flow path 115 may be disposed on a lower surface of the susceptor 110. A groove in a spiral form that connects to the outlet 115b for supplying the flow gas G2 may be disposed at the bottom of the pocket 111. The flow gas G1 discharged from the outlet 115b suspends the satellite disk 120 placed on the pocket 111 and thus a frictional force between the satellite disk 120 and the bottom of the pocket 111 may be significantly decreases due to a cushioning function of the flow gas G1 when rotating the satellite disk 120. Also, the flow gas G1 discharged from the outlet 115b is bent in a spiral form along the spiral groove connected to the outlet 115b and flows from an inner of the pocket 111 out of the pocket 111 so that the satellite disk 120 may be rotated by the flow gas G1. A flow gas exhaust pipe that may exhaust the flow gas G1 out of the susceptor 110 may be disposed in an edge of the pocket 111.

A material used to form the susceptor 110 may vary according to a method of heating a member disposed on the satellite disk 120 and on which a material is to be deposited. When induction heating is used, the susceptor 110 may be formed of a material that may be heated by induction heating. For example, the susceptor 110 may be formed of graphite. In order to strengthen durability of the susceptor 110, hardness strengthening coating may be performed on the susceptor 110. For example, the susceptor 110 may be formed by coating silicon carbide SiC on graphite.

As the susceptor 110 itself is heated, a member disposed thereon and on which a material is to be deposited is heated. Thus, degradation due to heat is generated, and accordingly, silicon carbide SiC coated on the susceptor 110 may be removed or the susceptor 110 may be broken. For example, due to a difference between a temperature of the susceptor 110 and a temperature of the flow gas G1 as the flow gas G1 passes through the susceptor flow path 115, elements surrounding the susceptor flow path 115 as the flow gas G1 passes through the path 115 are vulnerable to heat shock and thus may break. Also, the susceptor 110 may be broken by carelessness of a worker.

When a general susceptor is damaged, quality of a member deposited on the susceptor and on which a material is to be deposited is deteriorated and thus the susceptor, which may be expensive, needs to be changed. However, in the CVD apparatus 100 according to the current embodiment of the present invention, only a damaged susceptor slice from among the plurality of susceptor slices 110-1, 110-2, 110-3, 110-4, 110-5, 110-6, 110-7, and 110-8 is changed and thus a maintenance fee may be significantly reduced.

The supporters 130, 140, and 150, which supports the susceptor 110, may include a supporting disk 130 disposed below the susceptor 110, an upper joining plate 140 disposed on top of the susceptor 110, and a supporting tube 150 as a shaft combined to the supporting disk 130. The upper joining plate 140 and the supporting disk 130 may be connected to each other by using a well-known connection member, and the susceptor 110 interposed between the upper joining plate 140 and the supporting disk 130 is fixed with respect to the supporting disk 130. The supporting disk 130 is combined to the supporting tube 150 and the supporting tube 150 is connected to a flow gas injector 160.

The supporting disk 130 includes a supporting disk flow path 135 through which the flow gas G1 flows. The supporting disk flow path 135 is connected to a supporting tube flow path 155 of the supporting tube 150, and an outlet 135a of the supporting disk flow path 135 is disposed on a peripheral surface of the supporting disk 130. When the supporting disk 130 is partially inserted into the hole 110a of the susceptor 110, the outlet 135a of the supporting disk flow path 135 faces the inlet 115a of the susceptor flow path 115. In FIG. 2, the outlet 135a of the supporting disk flow path 135 has a one to one correspondence with the inlet 115a of the susceptor flow path 115; however, the present invention is not limited thereto. As another example, a plurality of inlets 115a that are adjacent to each other of the susceptor flow path 115 may be connected to each other and connected to the outlet 135a of the supporting disk flow path 135. A material used to form the supporting disk 130 is not particularly restricted. For example, the supporting disk 130 may be formed of a metal material. The supporting tube 150 may be a hollow shaft or a rod. The supporting tube 150 includes the supporting tube flow path 155 so as to connect an injector flow path 165 of the flow gas injector 160 with the supporting tube flow path 155 of the supporting tube 150.

In the current embodiment, since the inlet 115a of the susceptor flow path 115 is disposed in the side of the hole 110a of the susceptor 110, the flow gas G1 flows horizontally from the supporting disk flow path 135 to the inlet 115a of the susceptor flow path 115; however, the present invention is not limited thereto. For example, the inlet 115a of the susceptor flow path 115 may be disposed on a rear surface of the susceptor 110 and the flow gas G1 flows vertically from the supporting disk flow path 135 to the inlet 115a of the susceptor flow path 115.

The flow gas injector 160 is connected to a flow gas supply line 169 so as to inject the flow gas G1 to the supporting tube flow path 155 of the supporting tube 150 and transmits a rotating force of a driving motor 170 to the supporting tube 150. Here, in order to make the chamber 190 airtight, a ferro fluid seal may be used in a gap between the flow gas injector 160 and the chamber 190.

The flow gas G1 may be nitrogen and a flow amount of the flow gas G1 supplied to the flow gas supply line 169 may be adjusted so as to actively control rotation of the disk type satellite disk 120 in each pocket 111. In addition, a flow amount of the flow gas G1 may be adjusted in each of the plurality of pockets 111 or in bundles of the plurality of pockets 111 so as to control rotation of the disk type satellite disk 120 in each pocket 111.

The heater 175 heats the susceptor 110 to a predetermined temperature. The heater 175 may heat the susceptor 110 to a temperature within a few hundred to about a thousand degrees Celsius. For example, when a GaN-based growth layer is formed, the susceptor 110 may be heated to a temperature within about 700 to about 1300 °C. The heater 175 may be a coil to which a high-frequency current is applied, and in this regard, the susceptor 110 may be heated using induction heating. As another example, the heater 175 may be a leading wire that is resistance heated.

The reaction gas injector 180 supplies the reaction gas G2 including a source gas and a carrier gas to be deposited on a member on which a material is to be deposited. The nozzle 185 of the reaction gas injector 180 is exposed to the chamber 190 and discharges the reaction gas G2 through a nozzle hole 185a of the nozzle 185.

A member on which a material is to be deposited, such as a wafer, is placed on the satellite disk 120. In order to not move the member, a rim (not illustrated) may be disposed around the satellite disk 120.

The member is maintained at a high temperature by the susceptor 110 heated to a high temperature, and an upper surface of the member contacts the reaction gas G2 and thus a chemical deposition reaction may occur. Due to the chemical deposition reaction, a predetermined material such as a GaN-based compound may be crystal grown on the member.

The chamber 190 contains the susceptor 110 and the nozzle 185 of the reaction gas injector 180, is closed during a deposition process, and may be opened in order to change a member on which a material is to be deposited.

The gas discharger 195 discharges the flow gas G1 and the reaction gas G2 in the chamber 190.

In the current embodiment, the susceptor 110 is only formed of the susceptor slices 110-1, 110-2, 110-3, 110-4, 110-5, 110-6, 110-7, and 110-8; however, the present invention is not limited thereto. For example, the susceptor 110 may have a sandwich structure including a lower plate formed of the susceptor slices 110-1, 110-2, 110-3, 110-4, 110-5, 110-6, 110-7, and 110-8 and an upper plate covering the lower plate. Here, the upper plate has a shape corresponding to the pockets 111, and the susceptor flow path 115 or a pattern of the bottom of the pocket 111 may be disposed on the susceptor slices 110-1, 110-2, 110-3, 110-4, 110-5, 110-6, 110-7, and 110-8 of the lower plate.

As described above, in the susceptor and CVD apparatus according to the one or more of the above embodiments of the present invention, when the susceptor is partially damaged, only a damaged susceptor slice is replaced and thus a maintenance cost may be significantly reduced. Also, the susceptor is formed of separatable slices and thus thermal stress of the susceptor may be reduced and durability of the susceptor may be extended.

It should be understood that the exemplary embodiments described therein should be considered in a descriptive sense only and not for purposes of limitation. Descriptions of features or aspects within each embodiment should typically be considered as available for other similar features or aspects in other embodiments.

## Claims

1. A susceptor for a disk-form chemical vapor deposition (CVD) apparatus, the susceptor comprising:
a plurality of susceptor slices that form a disk when combined together; and
at least one pocket disposed on an upper surface of each of the plurality of susceptor slices and containing a member on which a material is to be deposited,
wherein, a connection part is formed between side surfaces of neighboring susceptor slices and allows the plurality of susceptor slices to be combined to each other in a separable/detachable manner.

2. The susceptor of claim 1, wherein the plurality of susceptor slices each are fan shaped.

3. The susceptor of claim 1, wherein the connection part comprises a concave portion formed on one side of each of the plurality of susceptor slices and a convex portion formed on another side of each of the plurality of susceptor slices, the concave portion and the convex portion being engaged with each other.

4. The susceptor of claim 1, wherein the connection part comprises a groove part formed on one side of each of the plurality of susceptor slices and extending long in a diameter direction, and a protrusion part formed on another side of each of the plurality of susceptor slices.

5. The susceptor of claim 1, wherein each of the plurality of susceptor slices comprises a susceptor flow path that supplies a flow gas to the at least one pocket.

6. A chemical vapor deposition (CVD) apparatus comprising:
a susceptor comprising a plurality of susceptor slices that form a disk when combined together and at least one pocket disposed on an upper surface of each of the plurality of susceptor slices and containing a member on which a material is to be deposited;
supporters for supporting the susceptor while injecting a flow gas to the susceptor to rotate the member;
a reaction gas injector for injecting a reaction gas including a deposition material to be deposited on the member; and
a chamber comprising the susceptor, the supporters, and the reaction gas injector,
wherein a connection part is formed between side surfaces of neighboring susceptor slices and allows the plurality of susceptor slices to be combined to each other in a separable/detachable manner.

7. The apparatus of claim 6, wherein the plurality of susceptor slices each are fan shaped.

8. The apparatus of claim 6, wherein the connection part comprises a concave portion formed on one side of each of the plurality of susceptor slices and a convex portion formed on another side of each of the plurality of susceptor slices, the concave portion and the convex portion being engaged with each other.

9. The apparatus of claim 6, wherein the connection part comprises a groove part formed on one side of each of the plurality of susceptor slices and extending long in a diameter direction, and a protrusion part formed on another side of each of the plurality of susceptor slices.

10. The apparatus of claim 6, wherein each of the plurality of susceptor slices comprises a susceptor flow path that supplies a flow gas to the at least one pocket.
